Europäisches Patentamt

European Patent Office

Office européen des brevets

(11) Publication number: **0 176 799**
**B1**

# EUROPEAN PATENT SPECIFICATION

(45) Date of publication of patent specification: 04.01.89

(51) Int. Cl.⁴: **H 03 K 19/086,** H 03 K 19/013

(21) Application number: 85111239.1

(22) Date of filing: 05.09.85

(54) Emitter coupled logic circuit.

(30) Priority: 25.09.84 JP 198606/84

(43) Date of publication of application:
09.04.86 Bulletin 86/15

(45) Publication of the grant of the patent:
04.01.89 Bulletin 89/01

(84) Designated Contracting States:
DE FR GB

(56) References cited:
EP-A-0 028 293
DE-A-2 751 881
DE-A-3 135 952
GB-A- 907 662
US-A-3 448 396
US-A-4 347 446
PATENT ABSTRACTS OF JAPAN, vol. 7, no. 40
(E-159)1185r, 17th February 1983; & JP - A - 57
192 135 (NIPPON DENKI K.K.) 26-11-1982
IBM TECHNICAL DISCLOSURE BULLETIN, vol.
21, no. 3, August 1978, page 1261; P.M.
SOLOMON "Schottky-damped emitter-
stabilized direct-coupled transistor logic"
IBM TECHNICAL DISCLOSURE BULLETIN, vol.
25, no. 1, June 1982, pages 323-325; D.B.
EARDLEY et al.: "Modifying current switch
emitter follower to include push-pull output
with speed-up capacitor"

(73) Proprietor: FUJITSU LIMITED
1015, Kamikodanaka Nakahara-ku
Kawasaki-shi Kanagawa 211 (JP)

(72) Inventor: Kanai, Yasunori
536-5-2-401, Ohmura
Inagi-shi Tokyo, 206 (JP)
Inventor: Saitoh, Taichi
54-10-1211, Shiratoridai Midori-ku
Yokohama-shi Kanagawa, 227 (GB)

(74) Representative: Schmidt-Evers, Jürgen, Dipl.-
Ing. et al
Patentanwälte Dipl.-Ing. H. Mitscherlich Dipl.-
Ing. K. Gunschmann Dipl.-Ing. Dr.rer.nat. W.
Körber Dipl.-Ing. J. Schmidt-Evers Dipl.-Ing. W.
Melzer Steinsdorfstrasse 10
D-8000 München 22 (DE)

(56) References cited:
PATENT ABSTRACTS OF JAPAN, vol. 8, no. 84
(E-239)1521r, 18th April 1984; & JP - A - 59 4222
(FUJITSU K.K.) 11-01-1984

Courier Press, Leamington Spa, England.

## Description

### Background of the invention

The present invention relates to an ECL (Emitter Coupled Logic) circuit, more specifically to an ECL circuit of which power consumption per gate is small but the propagation delay time does not become large when it is used for driving a large capacitive lord or a large fan-out circuit.

It is known that in an ECL circuit, each of the transistors in the circuit operates in a non-saturation mode, so a small signal operation of the logic circuit is possible that enables a quicker operation compared to other logic circuits. Therefore, ECL circuits are used very widely for a logic circuit which requires a high speed operation. And they are sometimes called CML (Current Mode Logic) circuits. But as the integration of the elements in LSI (large scale integrated circuits) increases, the power consumption of the circuit because very important to decrease the heat generation in the LSI chips. So it is desirable to make the circuit operate with as small current as possible.

But when the circuit is made to operate with a small current, its ability to drive a large capacitive load or a large fan-out circuit is decreased. Moreover, the operation speed decreases or the propagation delay time of the signal increases because of the parasitic capacity of the load or the fan-out circuits. This is another difficulty to be solved or compromised in the LSI circuit design.

### Description of prior art

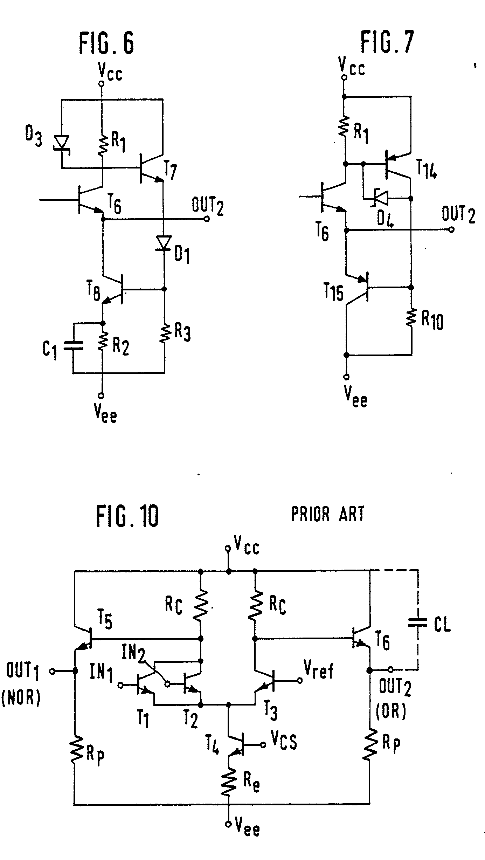

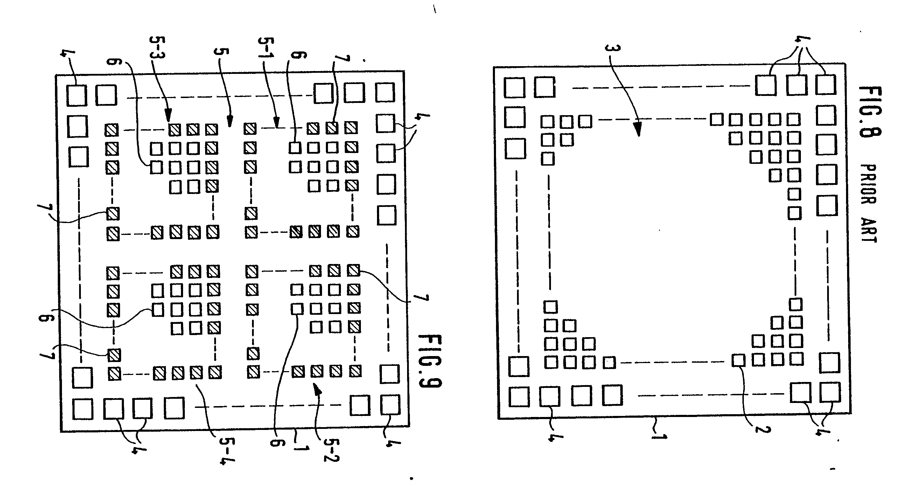

To clarify the advantage of the present invention over the prior art, a prior art ECL circuit will be described briefly with regard to an example of OR and NOR circuit as shown in Fig. 10. The figure shows a fundamental configuration of the ECL circuit. As shown in the figure, the ECL circuit comprises at least a pair of transistors T1 and T3 of which emitters are coupled to each other. In Fig. 10, another transistor T2 is connected in parallel to the transistor T1 to provide a dual input IN1 and IN2 for each of the bases. Collectors of these pair transistors are connected to a positive voltage source Vcc via respective collector resistor Rc. The emitters of these transistors are coupled to each other, and connected to a constant current source which is composed from a series connected transistor T4 and a resistor Re connected to a negative voltage source Vee. A control voltage Vcs is supplied to the base of the transistor T4 to provide a constant current through the transistor T4. The base of the transistor T3 is supplied with a reference voltage Vref which determines the threshold level of the transistors T1 and T2.

Between the Vcc and Vee are provided in parallel two emitter follower circuits respectively composed by a series connection of a transistor T5 and a resistor Rp, or a transistor T6 and a resistor Rp. Each collector of the pair transistors T1/T2 and T3 are respectively connected to the base of the transistors T5 and T6, and forms an emitter follower output circuit to provide a low impedance output OUT1 and OUT2 from respective emitters.

The operation of the circuit of Fig. 10 is as follows. If one or both of the dual input IN1 or IN2 is high voltage (H), one or both of the transistors T1 or T2 become conductive (ON), and the transistor T3 is cut off (OFF). Then the base voltage of the transistor T5 becomes low voltage (L), and the base voltage of the transistor T6 becomes H. So the output of the OUT1 becomes L, and the output of the OUT2 becomes H. On the contrary, if both the IN1 and IN2 are L the transistors T1 and T2 are cut off, and the transistor T3 becomes ON. So, the transistor T5 is ON and the OUT1 becomes H, but the transistor T6 is OFF and the OUT2 becomes L. This means that the output terminal OUT1 provides a NOR and the OUT2 provides an OR output signal against the input signal to the dual input terminals IN1 and IN2.

In the ECL circuits as shown in Fig. 10, each of transistors operates in a non-saturated state, so a small signal operation of the logic is possible, and a very high speed switching of signal can be attained compared to other logic circuits. But when the load is high capacitive or the circuit is intended to drive a large fan-out circuit, the propagation delay time of the signal increase. This delay is especially large when the output signal varies from H to L compared to when the output signal varies from L to H, because of the emitter follower transistors T5 and T6.

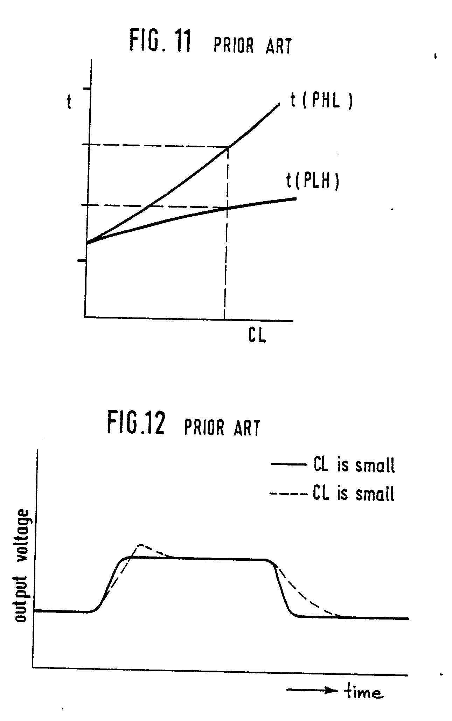

In Fig. 11 is shown the variation of the delay time t of the signal against the increase of the capacitive load CL. Both are in arbitrary scale. The curve t(PLH) indicates the variation of the signal propagation delay time when the output signal varies from L to H level, that is the voltage buildup. The curve t(PHL) indicates the variation of the signal propagation delay time when the output signal varies from H to L level, that is the build down of the voltage.

These curves corresponds respectively to the left and right hand sides of the pulse shown in Fig. 12. In Fig. 12, the curve of solid line indicates the wave form when the capacitive load CL is small, and the dashed line indicate the wave form when the CL is large. As can be seen in the figures the influence of the capacitive load is larger in the voltage build down (right hand side) than that in the voltage buildup (left hand side).

The reason for this is considered as follows. In Fig. 10, the capacitive load is represented as CL shown by a broken line at the OUT2 side. The phenomena will be described with regard to the OUT2 side of the circuit, but it is quite the same for the OUT1 side. When the transistor T6 is cut off, the capacitive load CL (that is a stray capacity) is charged up to the voltage equal to the source voltage Vee. When the transistor T6 is ON, the CL is discharged through the transistor T6. Since T6 is in an emitter follower operation and has a low impedance, the discharge is done comparatively quickly and the dependence of the voltage buildup time to the capacitance is small. On the contrary, when the transistor T6 comes to cut off again, the capacity CL should be charged up through the resistor Rp. Therefore, the rp should be small to reduce the time for charge up. But if the resistance of Rp is made small, the current runs through the circuit increases. It is undesirable to increase the current to reduce the heat generation in the IC. So the delay time of the voltage build down t(PHL) becomes larger compared to that of voltage build up t(PLH).

In the above description the capacitive load CL has been loaded between the emitter of the transistor T6 and the source voltage Vcc (Fig. 10). But it will be clear for the one skilled in the art that the stray capacitance may also appear between the OUT2 and the Vee or ground But it will be clear that, the above description can be extended easily to such cases.

As mentioned before, when the integration scale in ICs increases, the line length to interconnect the internal circuits increases, but the current of the circuit must be reduced to avoid the heat problem, and when the current is reduced, the delay time increases.

Summary of the invention

An object of the present invention, therefore, is to provide an ECL circuit whose power consumption is small and has an ability to drive a large capacitive load or a large fan-out circuit without increasing the delay of the signal.

In order to attain the above object, the present invention as defined in the claims provides a means to drive the load and pull down the voltage quickly when the emitter follower transistor of the ECL circuit (T6 for example) is cut off.

Said means comprises a detector means which detects the current at the collector of the emitter follower transistor, and controls a current control transistor inserted between the emitter of the emitter follower transistor and the Vee to pull down quickly the voltage of the load line when the emitter follower transistor is cut off.

US—A—3 448 396 (Conant) published 03.06.1969 teaches an emitter follower circuit which has the same structure as that proposed for the output stage of an ECL circuit in the present application but that teaching is solely in relation to linear amplifiers. There is no suggestion in that document that such a structure would be appropriate for logic circuits, in particular emitter-coupled logic circuits, where the problem is rather one of maintaining switching speed with a large fan-out or other capacitive load.

The means mentioned above may be modified in various ways. Details of the invention and these modifications will become clear from a reading of the detailed description of the preferred embodiments of the invention with reference to the accompanying drawings.

Brief description of the drawings

Fig. 1 is a circuit diagram of a first embodiment of the ECL circuit by the present invention.

Fig. 2 shows a wave forms of signal at various part of the circuit of Fig. 1.

Fig. 3 shows wave forms of output signal simulated by computer.

Fig. 4 is a circuit diagram for a second embodiment of the ECL circuit by the present invention.

Fig. 5 is a circuit diagram for a third embodiment of the ECL circuit by the present invention.

Fig. 6 is a circuit diagram for a fourth embodiment of the ECL circuit by the present invention.

Fig. 7 is a circuit diagram for a fifth embodiment of the ECL circuit by the present invention.

Fig. 8 is a plan view of a typical LSI chip showing an ordinary lay out of the devices on the chip.

Fig. 9 is a plan view of another type of LSI chip showing an arrangement of the devices on the chip.

Fig. 10 is a circuit diagram for a typical ECL circuit of prior art realizing an OR and an NOR circuit.

Fig. 11 is a graph depicting the variation of the delay time of signal in the ECL circuit by the variation of capacitive load.

Fig. 12 is a graph illustrating the delay of the signal especially at the voltage buildup and build down part of the signal.

Throughout the drawings, the same or similar parts are designated by same or similar symbols or reference numerals.

Description of preferred embodiments

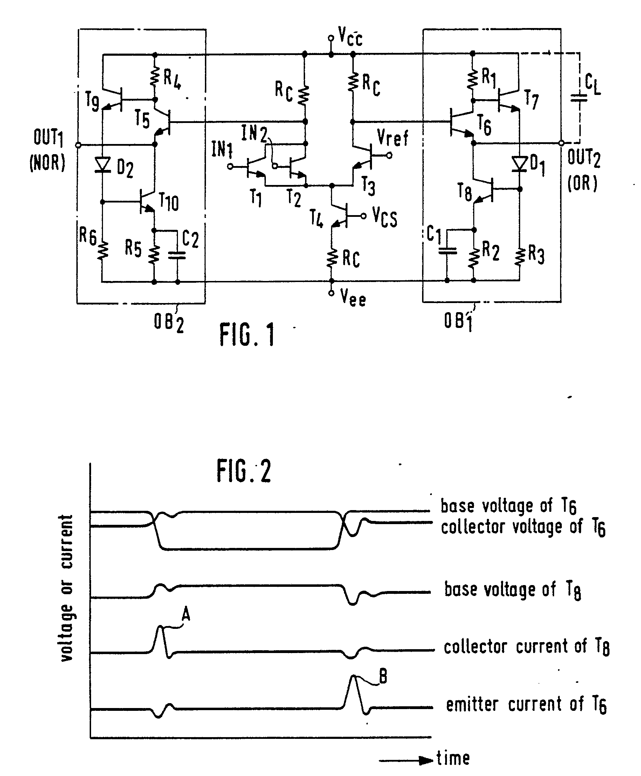

Fig. 1 shows a circuit diagram for an embodiment of the present invention. The figure shows an ECL circuit corresponding to that of Fig. 10 which realizes a two input OR and NOR gate. In the following description, the disclosure will be given with respect to the OR and NOR gate such as shown in Figs. 1 or 10. But it will become clear that the application of the present invention is not limited to such circuit, since there are various kinds of ECL circuits, the present invention is applicable to any of those ECL circuits.

Comparing the circuit of Fig. 1 with that of Fig. 10, each of the emitter follower circuits of Fig. 1 has been replaced by an output circuit which is indicated by OB1 and OB2 respectively surrounded by a chained lines. The center part of the circuit of Fig. 1 is same to that of Fig. 10, namely the ordinary two input OR and NOR circuit. So the description will be omitted for the sake of simplicity. The description will be given with regard to the OR gate side that is the right hand side of the circuit, but it will be clear that the configuration and the operation of the output circuit is similar for the left hand side of the circuit.

The output circuit (OBs) are provided with a resistor R1 and a transistor T7 on the collector side of the emitter follower transistor T6. The resistor R1 is connected between the voltage supply source Vcc and the collector of the transistor T6, and provides a voltage corresponding to the current running through the transistor T6 to the base of the detecting transistor T7.

The series resistor Rp in Fig. 10 is replaced by a current control transistor T8 and a resistor R2, connected to each other in series between the emitter of T6 and the negative side of voltage source Vee. And the resistor R2 is bypassed by a capacitor C1. The base of the transistor T8 is connected to Vee through a resistor R3, and the base of the current control transistor T8 is supplied with the output voltage of the detecting transistor T7 through a level shift diode D1.

Operation of the circuit is as follows. As mentioned before with regard to Fig. 10, when the base of the transistor T6 becomes low level (L), because of the load capacitance CL, the voltage level of the emitter of the transistor T6, which is the output OUT2, can not respond quickly. Therefore, the transistor T6 becomes cut off so that the collector of T6 becomes high because of no voltage drop at the resistor R1. Then the base of the detecting transistor T7 goes up so that it becomes conductive (ON). So the emitter of T7 becomes high and this voltage is supplied to the base of the current control transistor T8 through the level shift diode D1. So the transistor T8 becomes conductive and the load capacitance CL is charged up through the path of CL—T8—R2—Vee. Since the resistor R2 is bypassed by the capacitor C1, the impedance of the above charging path is low. Therefore, the fall time of the output voltage of OUT2 is as quick as its rise time.

When the base of the emitter follower transistor T6 is brought to high level (H), the load capacitance CL is discharged through the low impedance emitter follower transistor T6 quickly, and the OUT2 becomes quickly H. And furthermore, since the base of the transistor T7 becomes L level, the base of the transistor T8 also becomes L, so that the transistor T8 becomes OFF state. Therefore, the build up time of the OUT2 is faster than the prior art circuit.

Above process of operation will become more apparent from an inspection of Fig. 2, which depicts the wave forms of signal at various points in the circuit of Fig. 1. The curves were obtained by a computer aided simulation of the circuit operation. It is difficult to observe the wave form of the ECL circuit directly, for the measurement itself distorts the wave form. It should be pointed out that the collector current of T8 has a shape pulse A. This corresponds to a rush current for charging up the load capacitor CL. And it means that the charge up is completed by this pulse current and in the remainder part of the time the T8 almost does not flows the current. It is due to the fact that the capacitance of the C1 is selected larger than that of the load capacitance CL. Similarly the emitter current of the emitter follower transistor T6 is almost zero except the peak current B, which corresponds to the rush current to discharge CL.

Compared to the circuit of Fig. 10, in which the charging current runs continuously through the resistor Rp, in the circuit of Fig. 1, one of the transistor T6 or T8 are cut off when the other is in the conductive state. So the voltage source Vcc—Vee is only have to supply the rush current A and B in Fig. 2, therefore, the charging current is decreased to a greater extent. Moreover, the emitter follower transistor T6 is only have to flow the current to charge up the load capacitance CL and it does not need to flow current through the resistor Rp (Fig. 10). This decreases the load of the transistor T6 and further increases the speed to raise up the output voltage of OUT2.

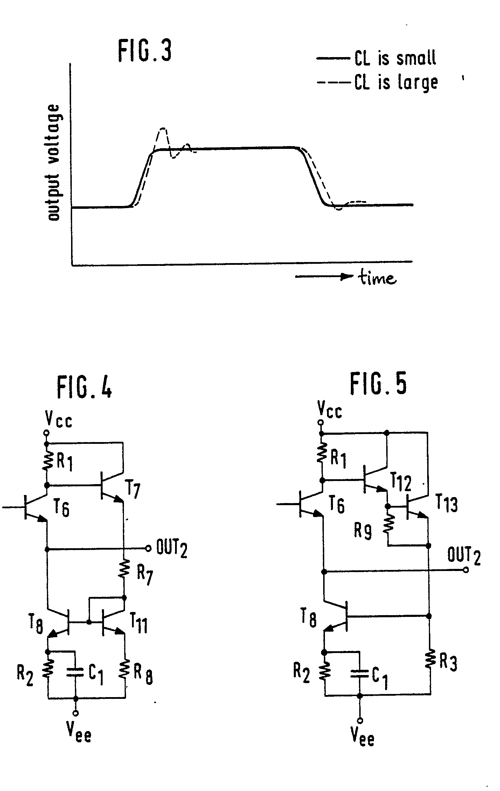

Fig. 3 shows a computer simulated wave form of the output signal. In the figure, the solid line shows the output wave form when the load capacitance is small (small fan-out), simulating a case when the capacity is 0.1 pF and the wiring length is 0.5 mm. The dashed line shows the output wave form when the load capacity is large (large fan-out), simulating a case when the capacity is 0.6 pF and the wiring length is 3 mm. Comparing these curves with those of Fig. 12, whose condition for the simulation is same, it will be noticed that the wave form for the small load capacitance or for the small fan-out (solid line curve) is almost same, but for the large capacitance or large fan-out (dashed line curve) the fall down of the pulse is improved to a greater extent, and the rise up of the pulse is also still improved. This indicates that the circuit by the present invention has improved the driving ability of the ECL circuit for large the large capacitance or large fan-out circuit to a greater extent.

Fig. 4 shows an output circuit diagram of the ECL circuit for a second embodiment of the present invention, which is a modification of the circuit of Fig. 1. In this embodiment, the emitter signal of the detecting transistor T7 is fed to the base of the current control transistor T8 by a circuit composed by a series connection of a resistor R7, a transistor T11 and a resistor R8. In this case, the transistors T8 and T11 composes a current mirror circuit. Therefore, when the base of the transistor T6 becomes L so that the transistor T6 is cut off and the current through the transistor T7 increases, the current through the transistor T8 also increases and the capacitive load (not shown and it will be omitted from the drawings hereinafter) is charged up quickly. So the fall of the output OUT2 is improved. And when the base of the transistor T6 becomes H so that the transistor T6 comes to conductive again and the current through the transistor T7 decreases, the current of the transistor T8 decreases. This decreases the load of the emitter follower transistor T6. So the rise of the signal is also improved.

Fig. 5 shows an output circuit diagram of a third embodiment of the present invention. In this embodiment, the detecting transistor T7 in Fig. 1 has been replaced by a Darlington pair transistors T12 and T13, and the level shift diode D1 has been omitted. A resistor R9 is inserted between the emitter of T12 and the resistor R3 to keep the transistor T12 always operative. In this circuit, the collector load of the emitter follower transistor T6 is further decreased, so the response to the buildup of the output signal is further increased compared to the above mentioned embodiments. This was certified by computer aided simulation of the circuit operation.

Fig. 6 is a circuit diagram for an output circuit of a fourth embodiment of the present invention. In this embodiment, a Shottky clamp diode D3 is inserted in parallel to the resistor R1 of Fig. 1. It is intended to avoid the saturation of the emitter follower transistor T6, and intended to further improve the high speed operation of the transistor T6.

Fig. 7 shows a fifth embodiment of the output circuit for an ECL circuit by the present invention. This circuit comprises a pnp type detecting transistor T14 whose base is connected to the collector of the emitter follower transistor T6. The emitter and collector of the transistor T14 are respectively connected to the positive side of the voltage source Vcc, and to the base of a pnp type control transistor T15. A Shottky clamp diode D4 is provided between the base and collector of T14 to avoid the saturation of the transistor T14. The current control transistor T15 which is a pnp type transistor is connected between the emitter of the emitter follower transistor T6 and the negative side of the voltage source Vee. The emitter and collector of the current control transistor T15 are connected to the emitter of T6 and Vee respectively. And a resistor R10 is connected between the base of the current control transistor T15 and Vee to keep the detecting transistor T14 always operative. The output OUT2 is taken out from the emitter of T6.

Operation of the circuit of Fig. 7 is as follows. When the base voltage of the emitter follower transistor T6 is switched from H to L, the base of T14 shifts from L to H and T14 is cut off. So the base voltage of the current control transistor T15 is pulled down by the resistor R10, and it becomes conductive, thus the load capacitor (CL not shown) is charged up quickly through the transistor T15 and the output voltage is pulled down quickly. When the base voltage of the transistor T6 is switched from L to H, the transistor T14 becomes ON, and the base voltage of T15 becomes high, and it is cut off. So the load of the emitter follower transistor T6 is reduced (compared to the circuit of Fig. 10), and the voltage build up of the output signal becomes sharper.

Fig. 8 shows a typical lay out of circuit elements in ordinary gate array LSI chip. On the chip 1 is provided a cell array 3 which is composed from unit cells 2 arranged in a matrix, and input/output (I/O) buffer circuits 4 which are arranged on the periphery of the chip 1. The circuit by the present invention described above are preferable to use as the unit cell 2. By doing so, the total heat generation in the chip is reduced, and the switching speed is increased.

But as can be seen in the circuit configurations of the present invention described above, the circuits of the present invention needs more elements than the prior art. Though the switching speed and fan-out number are increased and the total power consumption is decreased, the increase of the circuit elements may be one drawback of the present invention. The increase of the number of elements in each of the unit cells means an increase of the chip area. The chip area should be as small as possible to increase the number of chips on each of the semiconductor slices (wafers), because the number of chips per wafer means the number of chips available from one production sequence, and that is significant for cost reduction of the ICs.

To overcome the above difficulty, following lay out of devices on a chip is proposed by the inventors. Fig. 9 shows the lay out of the devices on a gate array LSI chip. This type of arrangement provides an I/O buffer cells 4 arranged on the periphery of the chip 1 and a unit cell array 5 arranged inside of the buffer cells 4. The unit cell array 5 is divided into several number of cell array blocks. In Fig. 9 for example, the cell array 5 is divided into four blocks 5-1, 5-2, 5-3 and 5-4, and in each of the cell array blocks are provided with a unit cells of first kind 6 arranged in matrix, and around them are provided unit cells of second kind 7 as shown in Fig. 9. As a unit cells of the first kind 6 are chosen as circuit like Fig. 10 for example, which has rather poor driving capacity but smaller size. And as a unit cells of the second kind 7 are used the circuits as shown in Fig. 1 for example which have a larger driving capacity.

The lay out of Fig. 9 has the following advantages. For the inter connections between the unit cells that is the wiring in the cell array block, a long wiring is unnecessary. So the unit cell of the first kind can realize its full ability, and small size. Since for the wirings between the cell array blocks or wirings between the cell array and the I/O buffer cells 4, the connecting wires become long, however, the unit cells of the second kind namely the circuit of the present invention is most applicable.

As has been described above, by the use of the present invention, it is possible to realize an ECL circuit of which power consumption is small but which has a large driving capacity for a large capacitive load or a large fan-out circuit. The disclosure has been given with respect to an OR and NOR circuit. But it is clear that the circuit of the present invention can be applied to any kind of ECL circuit. And it will be clear and easy for the one skilled in the art that the transistors used in the circuit may be altered from pnp type to npn type or vice versa with small modification of the circuit elements and polarity of the applied voltage.

**Claims**

1. Emitter coupled logic (ECL) circuit comprising:

at least a pair of transistors having emitters coupled to each other (T1/T2, T3);

an emitter follower transistor (T6), having a base connected to one of the collectors of said coupled transistors (T3);

an output terminal (OUT2) being connected to the emitter of the emitter follower transistor (T6);

a current control transistor (T8, T15) connected to the emitter of said emitter follower transistor (T6); and

a control circuit means for detecting the collector current of said emitter follower transistor (T6) and controlling the current through said current control transistor (T8, T15).

2. ECL circuit according to claim 1, wherein said control circuit means comprises:

a resistor (R1) connected between the collector of the emitter follower transistor (T6) and positive side of a voltage source (Vcc); and

a detecting transistor (T7, T14) whose base is connected to the collector of said emitter follower transistor (T6), and whose output is fed to the current control transistor (T8, T15).

3. ECL circuit according to claim 2, wherein said detecting transistor comprises a pair of transistors (T12, T13) connected in Darlington connection.

4. ECL circuit according to claim 1, wherein the emitter of said current control transistor (T8) is connected to a negative side of a voltage source (Vee) through a resistor (R2), and a capacitor (C1) is connected in parallel to said resistor (R2).

5. ECL circuit according to claim 2, wherein said detecting means further comprises a diode (D1) connected between the emitter of the detecting transistor (T7) and the base of the current control transistor (T8).

6. ECL circuit according to claim 2, wherein said control circuit means further comprises:

a clamp diode (D3) connected between the collector of said emitter follower transistor (T6) and the positive side of the voltage source (Vcc); and

a level shift diode (D1) connected between the emitter of the detecting transistor (T7) and the base of the current control transistor (T8).

7. ECL circuit according to claim 2, wherein said detecting means further comprises a clamp diode (D4) connected between the base and the collector of the detecting transistor (T14).

8. ECL circuit according to claim 2 further comprising a resistor (R3, R10) connected between the base of the current control transistor (T8) and the negative side of the voltage source (Vee).

9. ECL circuit according to claim 2, further comprising a series connected circuit comprising:

a first resistor (R7) connected to the emitter of the detecting transistor (T7);

a transistor (T11) whose base is connected to the base of the current control transistor (T8) and whose collector is connected to the other end of said first resistor (R7) and its own base; and

a second resistor (R8) connected between the emitter of said transistor (T11) and the negative side of the voltage source (Vee).

10. ECL circuit according to claim 2, said transistors are npn type transistors.

11. ECL circuit according to claim 2, wherein said detecting transistor and the current control transistor are pnp type transistors.

**Patentansprüche**

1. Emittergekoppelte Logikschaltung
mit wenigstens einem Paar von Transistoren (T1/T1, T3), deren Emitter miteinander verbunden sind,

mit einem Emitterfolger-Transistor (T6), dessen Basis mit einem der Kollektoren der miteinander verbundenen Transistoren (T3) verbunden ist,

mit einem Ausgangsanschluß (OUT2), der mit dem Emitter des Emitterfolger-Transistors (T6) verbunden ist,

mit einem Stromsteuertransistor (T8, T15), der mit dem Emitter des Emitterfolger-Transistors (T6) verbunden ist,

sowie mit einer Steuerschaltungsanordnung zur Detektierung des Kollektorstroms des Emitterfolger-Transistors (T6) zur Steuerung des Stroms durch den Stromsteuertransistor (T8, T15).

2. Emittergekoppelte Logikschaltung nach Anspruch 1, bei der die Steuerschaltungsanordnung

einen zwischen dem Kollektor des Emitterfolger-Transistors (T6) und dem Plus-Pol (Vcc) einer Spannungsquelle angeordneten Widerstand (R1)

und einen Detektortransistor T7, T14) enthält, dessen Basis mit dem Kollektor des Emitterfolger-Transistors (T6) verbunden ist und dessen Ausgangssignal dem Stromsteuertransistor (T8, T15) zugeführt wird.

3. Emittergekoppelte Logikschaltung nach Anspruch 2, bei der der Detektortransistor ein in Darlingtonschaltung angeordnetes Transistorpaar (T12, T13) umfaßt.

4. Emittergekoppelte Logikschaltung nach Anspruch 1, bei der der Emitter des Stromsteuertransistors (T8) über einen Widerstand (R2) mit dem Minus-Pol (Vee) einer Spannungsquelle verbunden ist und ein Kondensator (C1) zu diesem Widerstand (R2) parallel geschaltet ist.

5. Emittergekoppelte Logikschaltung nach Anspruch 2, bei der die Detektoranordnung ferner eine Diode (D1) umfaßt, die zwischen dem Emitter des Detektortransistors (T7) und der Basis des Stromsteuertransistors (T8) angeordnet ist.

6. Emittergekoppelte Logikschaltung nach Anspruch 2, bei der die Steuerschaltungsanordnung ferner eine zwischen dem Kollektor des Emitterfolger-Transistors (T6) und dem Plus-Pol (Vcc) der Spannungsquelle angeordnete Klemmdiode (D3).

sowie eine zwischen dem Emitter des Detektortransistors (T7) und der Basis des Stromsteuertransistors (T8) angeordnete Pegelverschiebungsdiode (D1) umfaßt.

7. Emittergekoppelte Logikschaltung nach Anspruch 1, bei der die Detektoranordnung ferner eine zwischen der Basis und dem Kollektor des Detektortransistors (T14) angeordnete Klemmdiode (D4) enthält.

8. Emittergekoppelte Logikschaltung nach Anspruch 2, bei der ferner zwischen der Basis des Stromsteuertransistors (T8) und dem Minus-Pol (Vee) der Spannungsquelle ein Widerstand (R3, R10) angeordnet ist.

9. Emittergekoppelte Logikschaltung nach Anspruch 2, bei der ferner eine Reihenschaltung vorgesehen ist, die folgende Teile umfaßt:

einen ersten Widerstand (R7), der mit dem Emitter des Detektortransistors (T7) verbunden ist,

einen Transistor (T11), dessen Basis mit der Basis des Stromsteuertransistors (T8) und dessen Kollektor mit dem anderen Ende des ersten Widerstand (R7) und seiner eigenen Basis verbunden ist,

sowie einen zweiten Widerstand (R8), der zwischen dem Emitter dieses Transistors (T11) und dem Minus-Pol (Vee) der Spannungsquelle angeordnet ist.

10. Emittergekoppelte Logikschaltung nach Anspruch 2, bei der die Transistoren npn-Transistoren sind.

11. Emittergekoppelte Logikschaltung nach Anspruch 2, bei der der Detektortransistor und der Stromsteuertransistor pnp-Transistoren sind.

## Revendications

1. Circuit logique à couplage par l'émetteur (ECL), comprenant:

au moins une paire de transistors dont les émetteurs sont mutuellement couplés (T1/T2, T3);

un transistor à émetteur suiveur (T6), dont la base est connectée à l'un des collecteurs desdits transistors couplés (T3);

une borne de sortie (OUT2) qui est connectée à l'émetteur du transistor à émetteur suiveur (T6);

un transistor de commande de courant (T8, T15) connecté à l'émetteur dudit transistor à émetteur suiveur (T6); et

un circuit de commande servant à détecter le courant de collecteur dudit transistor à émetteur suiveur (T6) et à commander le courant par l'intermédiaire dudit transistor de commande de courant (T8, T15).

2. Circuit ECL selon la revendication 1, où ledit circuit de commande comprend:

une résistance (R1) connectée entre le collecteur du transistor à émetteur suiveur (T6) et le côté positif d'une source de tension (Vcc); et

un transistor de détection (T7, T14) dont la base est connectée au collecteur dudit transistor à émetteur suiveur (T6) et dont le signal de sortie est fourni au transistor de commande de courant (T8, T15).

3. Circuit ECL selon la revendication 2, où ledit transistor de détection comprend une paire de transistors (T12, T13) connectés en montage Darlington.

4. Circuit ECL selon la revendication 1, où l'émetteur dudit transistor de commande de courant (T8) est connecté au côté négatif d'une source de tension (Vee) via une résistance (R2), et un condensateur (C1) est connecté en parallèle sur ladite résistance (R2).

5. Circuit ECL selon la revendication 2, où ledit moyen de détection comprend en outre une diode (D1) connectée entre l'émetteur du transistor de détection (T7) et la base du transistor de commande de courant (T8).

6. Circuit ECL selon la revendication 2, où ledit circuit de commande comprend en outre:

une diode de limitation (D3) connectée entre le collecteur dudit transistor à émetteur suiveur (T6) et le côté positif de la source de tension (Vcc); et

une diode de déplacement de niveau (D1) connectée entre l'émetteur du transistor de détection (T7) et la base du transistor de commande de courant (T8).

7. Circuit ECL selon la revendication 2, où ledit moyen de détection comprend en outre une diode de limitation (D4) connectée entre la base et le collecteur du transistor de détection (T14).

8. Circuit ECL selon la revendication 2, comprenant en outre une résistance (R3, R10) connectée entre la base du transistor de commande de courant (T8) et le côté négatif de la source de tension (Vee).

9. Circuit ECL selon la revendication 2, comprenant en outre un circuit connecté en série qui comprend:

une première résistance (R7) connectée à l'émetteur du transistor de détection (T7);

un transistor (T11) dont la base est connectée à la base du transistor de commande de courant (T8) et dont le collecteur est connecté à l'autre extrémité de ladite première résistance (R7) et à sa propre base; et

une deuxième résistance (R8) connectée entre l'émetteur dudit transistor (T11) et le côté négatif de la source de tension (Vee).

10. Circuit ECL selon la revendication 2, où lesdits transistors sont des transistors du type npn.

11. Circuit ECL selon la revendication 2, où ledit transistor de détection et le transistor de commande de courant sont des transistors du type pnp.

FIG. 1

FIG. 2

voltage or current

base voltage of $T_6$
collector voltage of $T_6$

base voltage of $T_8$

collector current of $T_8$

emitter current of $T_6$

time

# FIG.3

—— CL is small
--- CL is large

# FIG.4

# FIG.5

## FIG. 6

## FIG. 7

## FIG. 10

PRIOR ART

FIG.8 PRIOR ART

FIG.9

## FIG. 11 PRIOR ART

t(PHL)

t(PLH)

t

CL

## FIG.12 PRIOR ART

—— CL is small

---- CL is small

output voltage

time